(19)

Europäisches
Patentamt
European
Patent Office
Office européen
des brevets

(11) **EP 2 799 891 A1**

(12) **EUROPEAN PATENT APPLICATION**

(43) Date of publication:
**05.11.2014 Bulletin 2014/45**

(21) Application number: **13002385.6**

(22) Date of filing: **03.05.2013**

(51) Int Cl.:
*G01R 27/26* (2006.01)     *G01D 5/24* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Sensirion AG
8712 Stäfa (CH)**

(72) Inventors:
• **Steiner Vanha, Ralph
8634 Hombrechtikon (CH)**

• **Gonnet, Matthieu
8004 Zürich (CH)**
• **Ryter, Roland
8608 Bubikon (CH)**
• **Plüss, Marcel
8820 Wädenswil (CH)**

(74) Representative: **Toleti, Martin
c/o E.Blum & Co. AG
Vorderberg 11
8044 Zürich (CH)**

(54) **Sensor circuit arrangement**

(57)     In a sensor circuit arrangement, a capacitance of a sensor capacitor (1) is measured by a circuit (8) which supplies a corresponding sensor signal ($V_3$). The circuit (8) comprises a differential amplifier (2) with an input, an output and a feedback loop between the input and the output. It further comprises a first capacitor (3) arranged in the feedback loop, and a switching arrangement for charging the sensor capacitor (1) from a voltage source (5) in a first phase ($\Phi1$) and for transferring a charge from the sensor capacitor (1) to the integrating capacitor (3) in a second phase ($\Phi2$). The circuit (8) further comprises a second capacitor (6) arranged in parallel to the first capacitor (3) in the second phase ($\Phi2$) for limiting a gain of noise generated by the differential amplifier (2). The sensor circuit arrangement further includes a low pass filter (10) for filtering the sensor signal ($V_3$).

FIG. 4

EP 2 799 891 A1

**Description**

Technical Field

The invention refers to a sensor circuit arrangement, and to a method for determining a capacitance of a sensor capacitor.

Background Art

When sensing a variable by means of a capacitor, noise may play a critical role in a circuit for determining the capacitance of such capacitor.

Disclosure of the Invention

The problem to be solved by the present invention is therefore to provide an improved circuit arrangement and method for determining the capacitance of a capacitor used as a sensor.

This problem is solved by a sensor circuit arrangement according to the features of claim 1. Such sensor circuit arrangement comprises a sensor capacitor with a capacitance dependent on a variable to be measured. The variable to be measured in this respect may impact on one or more parameters, for example the dielectric of the capacitor, a distance between electrodes of the capacitor, an effective area of one or both of the electrodes of the capacitor or other parameters that may impact the capacitance of the capacitor. Given that such capacitor is used for sensing a variable, the capacitor is denoted as sensor capacitor. The variable to be measured may be, for example, a chemical substance, humidity, pressure, flow, distance, etc. For example, a layer of material sensitive to the variable to be measured may be arranged between the electrodes of the sensor capacitor such that upon receiving water in case of a humidity sensor, for example, a dielectric permittivity of the layer may change which change results in a change of the capacitance of the sensor capacitor. In another example, at least one of the electrodes of the sensor capacitor may be arranged on a movable membrane which membrane may be deflected subject to pressure acting onto the membrane. Hence, a distance between the electrodes may vary which changes the capacitance of the sensor capacitor. A third example refers to a change in the dielectric by a solid, liquid or gas that is present between the electrodes or not, e.g. in touch-screens. The sensor capacitor may refer to a single capacitor, or may refer to a capacitor arrangement for measuring the variable. In case of multiple individual capacitors and specifically in the case of two individual capacitors contributing to the sensor capacitor, the individual capacitors may exhibit a characteristic or be connected to each other such that both corresponding capacitances either increase or decrease in response to an increase of the variable. Or, the individual capacitors may exhibit a characteristic or be connected to each other such that one of the capacitances increases in response to an increase of the variable while the other capacitance decreases in response to the increase of the variable.

For determining the capacitance of the sensor capacitor and supplying a corresponding sensor signal, a circuit is provided which comprises a differential amplifier with an input, an output and a feedback loop between the input and the output which feedback loop is also known as return path. The differential amplifier, which in one embodiment may be an operational amplifier, is wired such that it may support determining the capacitance of the sensor capacitor. In one embodiment, a first capacitor is provided in the feedback loop for serving as recipient of charges supplied by the sensor capacitor. In a very preferred embodiment, the sensor capacitor is charged in a first phase by means of a voltage source while in a second phase the charge is transferred from the sensor capacitor to the first capacitor. For this purpose, the circuit may preferably comprise a switching arrangement with at least one first switch, preferably arranged in the feedback loop, for short-circuiting the first capacitor. The switching arrangement is adapted to close the first switch for short-circuiting the first capacitor in the first phase, and preferably during the entire first phase, and is adapted to open the first switch in the second phase, and preferably during the entire second phase. Specifically, the first phase may have a duration equal to the second phase. A cycle including the first phase followed by the second phase is repeated such that the charges that are transferred from the sensor capacitor are at least partly accumulated in a capacitor arrangement in the feedback loop including also a second capacitor. In one embodiment, this cycle of charging the sensor capacitor and transferring the charge from the sensor capacitor to this capacitor arrangement in the feedback loop may be repeated for a prescribed number of times. A voltage at the second capacitor, which at the same time may be a voltage at the output of the differential amplifier, may be a measure for the capacitance of the sensor capacitor after a transfer of charges for the prescribed number of times, and as such represent a sensor signal corresponding to the capacitance of the sensor capacitor. In another embodiment, the second capacitor may be charged in the accumulative manner as described above until a prescribed voltage threshold is reached at the second capacitor, or at the output of the differential amplifier. A repeated count of cycles to reach this threshold voltage may then produce a measure for the capacitance of the sensor capacitor and represent as such a sensor signal.

A switching arrangement is provided for effecting a charging of the sensor capacitor from the voltage source in the first phase and for transferring the charge from the sensor capacitor to the first capacitor in the second phase.

It was noticed that the differential amplifier may constitute a source of noise. What is in particular detrimental to this source of noise is that the noise becomes amplified by the generating device itself, i.e. the differential amplifier. In an effort to limit the impact of noise stemming from the differential amplifier, it is presently proposed to add the second capacitor in parallel to the first capacitor in the feedback loop during the second phase so that such that a gain of noise of the differential amplifier is reduced in the second phase.

While a low pass filter is provided subsequently for filtering the sensor signal as output of the above circuit for reading the capacitance of the sensor capacitor and thereby reduces high frequency noise from other circuits in between - such as an analogue to digital converter for the sensor signal, for example -, the present approach of limiting the amplifiers noise gain acts directly on the specific source of such noise, i.e. the differential amplifier.

The low-pass filter that follows the front-end, i.e. the circuit for determining the capacitance of the sensor capacitor, would have no effect on the noise generated by the differential amplifier for the reason that this noise is already amplified also in a frequency domain that carries the sensing information and as such needs to pass the low pass filter. However, the noise gain limiting second capacitor in the feedback loop of the differential amplifier reduces the gain of the noise generated by the differential amplifier without limiting while at the same time does not limit a gain of the sensing signal. The noise gain limiting capacitor only acts as a low-pass filter on the signal transfer function, but it does not limit the signal gain.

Hence, in order to limit the gain of noise generated by and amplified through the differential amplifier, the noise gain limiting capacitor denoted as second capacitor is arranged in parallel to the first capacitor in the second phase for limiting the gain of noise generated by the differential amplifier while it is disconnected from the first capacitor in the first phase such that this parallel circuit temporarily formed in the second phase is disconnected gain. Hence, it is preferred to have the noise gain limiting capacitor electrically connected in parallel to the first capacitor only in the second phase, e.g. during the entire second phase or in an interval within the second phase but of less duration than the second phase. The noise gain limiting capacitor may be connectable in parallel to the first capacitor by means of a second switch.

By this means, the gain of noise generated by the differential amplifier can be limited. Hence, a sensor signal representing a course of the variable to be measured over time may become more precise and reliable given that a noise source early in the processing chain is limited in its impact. The low pass filter subsequent to the differential amplifier in the electrical path processing the sensor signal is then preferably adjusted to cut off noise frequencies originating from other sources of noise such as an analogue to digital converter being connected in between the circuit for determining the capacitance of the sensor capacitor and the low pass filter, and to reduce noise from the amplifier as well as other noise sources, i.e. from switches, known as kT/C noise. Specifically, the analogue to digital converter may have the low-pass filter integrated. A cut-off frequency of the low pass filter preferably is less than 10 KHz. A cut-off frequency of the low pass filter is preferably smaller than a cut-off frequency of the low pass filter implemented by means of the second capacitor in the feedback loop of the differential amplifier.

The problem is further solved by a method for determining a capacitance of a sensor capacitor according to the features of claim 14. Accordingly, in a first phase the sensor capacitor is charged from a voltage source, and in a second phase following the first phase a charge is transferred from the sensor capacitor to a first capacitor arranged in a feedback loop of a differential amplifier to which first capacitor a second capacitor is arranged in parallel in the second phase for limiting a gain of noise generated by the differential amplifier. A sensor signal corresponding to the capacitance of the sensor capacitor is derived from an output of a circuit containing the differential amplifier, and the sensor signal is low-pass filtered, preferably after being supplied to an analogue to digital converter.

Other advantageous embodiments are listed in the dependent claims as well as in the description below.

Brief Description of the Drawings

The invention will be better understood and objects other than those set forth above will become apparent from the following detailed description of embodiments of the present invention. Such description makes reference to the annexed drawings, wherein:

> FIG. 1 illustrates equivalent circuits of sensor capacitors,
> FIG. 2 illustrates a circuit for determining a capacitance of a sensor capacitor,
> FIG. 3 illustrates a circuit for determining a capacitance of a sensor capacitor as used in a sensor circuit arrangement according to an embodiment of the present invention,
> FIG. 4 illustrates a sensor circuit arrangement according to an embodiment of the present invention, and
> FIG. 5-7 each illustrate a circuit for determining a capacitance of a sensor capacitor as used in a sensor circuit arrangement according to embodiments of the present invention.

Modes for Carrying Out the Invention

Similar or identical elements in the figures are referred to by the same reference signs.

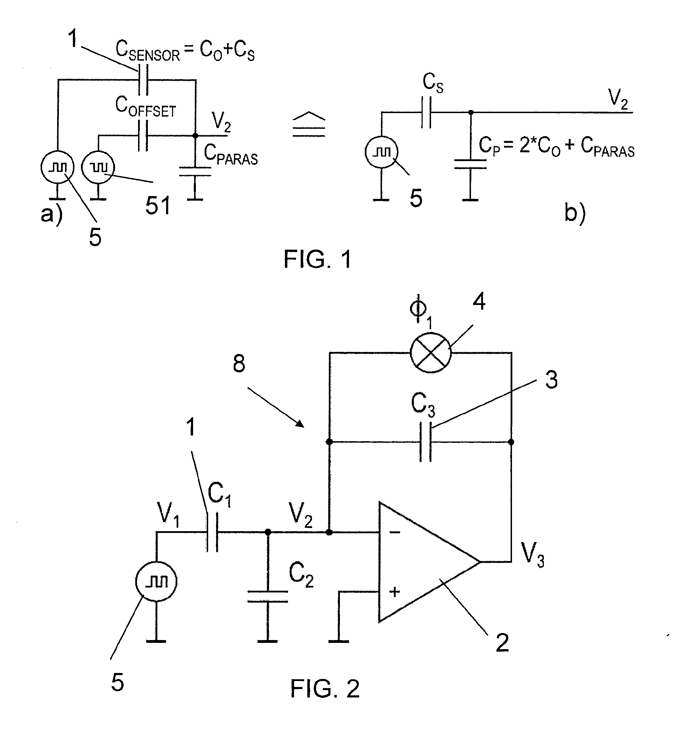

Figure 1 illustrates in diagram a) a circuit of a sensor capacitor 1 connected to a voltage source 5. The sensor capacitor 1 has a capacitance $C_{SENSOR}$ which changes in a variable portion $+/-C_S$ around a static offset portion $C_O$ independent from the variable to be measured, such that $C_{SENSOR} = C_O + C_S$. In the following, $C_{S,MAX}$ shall denote a maximum value of $C_S$ which typically is much smaller than $C_O$, e.g. a tenth of $C_O$. For measuring the variable portion $C_S$ of the capacitance $C_{SENSOR}$ of the sensor capacitor 1, typically a prescribed offset $C_{OFFSET} \sim C_O$ is subtracted from the capacitance $C_{SENSOR}$, wherein $C_{SENSOR}$ and $C_{OFFSET}$ are stimulated by two rectangular voltage sources 5, 51 with a phase-shift of 180° in between. Additionally, there typically is a parasitic capacitance $C_{PARAS}$ to ground which represents a sum of capacitances from the sensor itself, the wiring and circuitry.

Diagram 1b) in turn illustrates a simplified equivalent circuit to the circuit of diagram 1a), wherein solely the variable portion $C_S$ of the capacitance $C_{SENSOR}$ is stimulated by the voltage source 5 while the offset and the parasitic capacitances are summarized in a capacitance $C_P = 2*C_O + C_{PARAS}$ to ground.

In Figure 2, a circuit 8 for determining a capacitance of the sensor capacitor 1 is introduced. Although in this particular circuit, the sensor capacitor 1 actually denotes only the variable portion $C_S$ of the sensor capacitance $C_{SENSOR}$ such that $C_1$ represents $C_S$, and $C_2$ represents $C_P$, it is still referred to as sensor capacitor 1 though given that it is the variable portion that is of interest to be detected. The subject circuit 8 supplies a sensor signal $V_3$ at its output representing a capacitance of the sensor capacitor (irrespective if this capacitance constitutes only the variable portion or the total capacitance including the variable portion plus the offset portion). For this purpose, the sensor capacitor 1 is connected to an input of a differential amplifier 2 at which input the signal $V_2$ occurs. In the present embodiment the differential amplifier 2 is an inverted operational amplifier with a feedback loop. A first capacitor 3 is arranged in the feedback loop, which first capacitor 3 may be shunted by means of a first switch 4 arranged in parallel to the first capacitor 3. A voltage source 5 supplies a square wave voltage signal:

$$V(t) = \sum_{k=0}^{n} \begin{cases} 0, k \le t < k+0.5, \\ V_1, k+0.5 \le t < k+1 \end{cases}$$

The circuit 8 may in one embodiment operate as follows: In a first phase Φ1, the first switch 4 is closed such that the first capacitor 3 is shortcircuited. During the first phase Φ1, the voltage source 5 provides the voltage $V_1$ in the square wave voltage signal $V(t)$. As a result, the sensor capacitor 1 is charged from the voltage source 5 during the first phase Φ1.

During the second phase Φ2, the voltage source 5 provides the zero voltage in the square wave voltage signal $V(t)$ while at the same time the first switch 4 is open, in the present embodiment throughout the entire second phase Φ2. Hence, in the second phase Φ2, the charge on the sensor capacitor 1 is transferred to the first capacitor 3.

The first phase Φ1 followed by the second phase Φ2 may together build a cycle. A switching arrangement, and in particular a control unit thereof, controls the first switch 4 such that the closed state of the first switch 4 coincides with the times $k + 0.5 \le t < k + 1$ in which the voltage source supplies a voltage V = V1, while the open state of the first switch 4 coincides with times $k \le t < k + 0.5$ in which the voltage source 5 supplies a voltage V = 0. Given that the voltage source 5 preferably supplies a square wave voltage signal with voltages V = V1 and V = 0 of equal duration, the first phase Φ1 and the second phase Φ2 are of equal duration, too. The charge first charged in the sensor capacitor 1 and then transferred to the first capacitor 3 are converted into a voltage $V_3$ there. Given that the capacitance of the sensor capacitor 1 may be variable dependent on the variable to be measured, the charge transferred to the first capacitor 3 depend on the capacitance of the sensor capacitor 1. At each cycle, the first capacitor 3 is charged to a voltage value $V_3$ representing the capacitance of the sensor capacitor 1. After each cycle, the output signal $V_3$, also denoted as sensor signal, may be sampled and further processed.

Alternative to the voltage source 5 supplying a square wave voltage signal, a DC source may be connected to the sensor capacitor 1 by means of a further switch and a shunt switch, connecting the sensor capacitor 1 to ground (not shown). By alternate switching the further switch and the shunt switch, a square wave voltage signal may be generated, too. In this embodiment, the closing of the further switch to the DC source in the first phase Φ1 coincides with the closing of the first switch 4 for short-circuiting the first capacitor 3, while the opening of the further switch to the DC source and closing the shunt switch to ground coincides with the opening of the first switch 4 arranged in parallel to the first capacitor 3.

In the circuit 8 for determining the capacitance of the sensor capacitor 1, the differential amplifier 2 may generate noise. The differential amplifier 2 may contain multiple electronic elements, wiring etc. which may produce noise amplified by the differential amplifier with a gain of the differential amplifier.

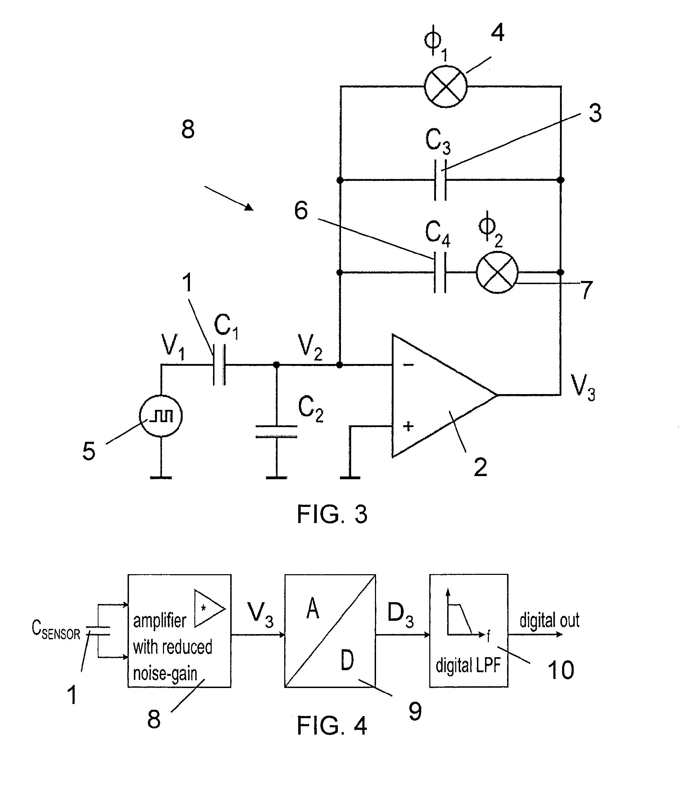

Figure 3 illustrates a circuit 8 for determining the capacitance of a sensor capacitor 1 according to an embodiment of the present invention. The present circuit 8 contains multiple elements identical to the circuit of Figure 2. Functionality and embodiments of Figure 2 shall be considered as disclosed in connection with Figure 3, too, where applicable. However, in the feedback loop, a noise gain limiting capacitor 6, i.e. a second capacitor 6 is additionally provided, which in the present example is connectable in parallel to the first capacitor 3 by means of a second switch 7. This second capacitor 6 limits the gain of noise generated by the differential amplifier 2.

Noise gain is the reciprocal of the feedback factor β of the closed feedback loop which is the transfer function from V2 to V3:

$$NTF = \frac{V_3}{V_2} = \frac{1}{\beta}$$

The noise transfer function NTF in the first phase Φ1, i.e. upon closure of the first switch 4, is always NTF=1 given that the output $V_3$ of the differential amplifier 2 is shunted to its input $V_2$. However, the noise transfer function NTF in the second phase Φ2, i.e. with open switch 4, is

$$NTF = \frac{C_1 + C_2 + C_3 + C_4}{C_3 + C_4}$$

By dimensioning the capacitance C4 the noise gain β can be influenced. Preferably, the capacitance C4 of the second capacitor 6 exceeds the capacitance C3 of the first capacitor 3, and preferably exceeds two times the capacitance C3 of the first capacitor 3, and preferably exceeds five times the capacitance C3 of the first capacitor 3.

The second switch 7 remains open in the first phase Φ1, i.e. the second capacitor 6 is not connected in parallel to the first capacitor 3. Hence, the second capacitor 6 is not discharged during phase Φ1 but remains at a charge level reached at the end of the previous second phase Φ1.

The second switch 7 is closed during the second phase Φ2, i.e. during the phase at which the first switch 4 is open. This means, that the first and the second capacitors 3 and 6 are arranged in parallel, while the short-circuit of the first capacitor 3 previously evoked by the closing of the first switch 4 is released: The first switch 4 is open during the second phase Φ2. The charge in the sensor capacitor 1 becomes transferred to a capacitor arrangement including the parallel circuit of the first and the second capacitor 3 and 6. Given that the first capacitor 4 was discharged during the previous first phase Φ1 due to the short-circuit, the charge transferred from the sensor capacitor 1 now becomes transferred to a large part into the first capacitor 1. The second capacitor 6, on the contrary, is in a precharged state from the previous cycle such that in view of a common voltage across the first and the second capacitors 3 and 6, the charges distribute according to the capacities C3 and C4. Summarizing, across multiple cycles, the charge accumulates on the second capacitor 6 and provides the sensor signal while the gain of noise stemming from the differential amplifier is reduced in view of the dimensioning of the very same second capacitor 6.

On the other hand, the gain of the sensor signal at the output V3 of the differential amplifier 2 is not affected and as a result a good signal to noise ration SNR can be achieved. The gain of the sensor signal is the reciprocal of the transfer function of the circuit including a closed feedback loop wherein the signal transfer function STF is:

$$STF = \frac{V_3}{V_1} = \frac{C_1}{C_3} \left( \frac{1}{1 + j\omega \dfrac{C_4}{C_3}} \right)$$

While any dimensioning of the second capacitor 6/C4 acts on a low pass filtering function with respect to the sensor signal, i.e. V3, the gain of the sensor signal V3 remains unaffected by C4.

Figure 4 illustrates a sensor circuit arrangement according to an embodiment of the present invention. While a sensor capacitor 1 is connected to a circuit 8 for determining a capacitance of the sensor capacitor 1 such as the one of Figure 3, the analogue sensor signal $V_3$ at the output of the circuit 8 is supplied to an analogue to digital converter 9 which supplies the digital sensor signal $D_3$ to a digital low pass filter (LPF) 10 in the present example. The analogue to digital converter 9 may be an oversampling converter such as e.g. a sigma-delta converter used for digitizing the measured sensor signal $V_3$. It is preferred that the oversampling converter 9 is followed by a digital low-pass and decimation filter 10 in order to reduce the quantization noise and also the noise from the analogue front-end circuit 8.

Given that the noise gain limiting capacitor 6 of Figure 4 also contributes to a low pass filtering function in circuit 8 - denoted as noise gain limiter in the following - it may be of interest to further determine the characteristics of such noise gain limiter compared to the subsequent low pass filter 10. A cut-off frequency of the noise gain limiter in a preferred embodiment is dimensioned at least five times as high as a cut off frequency of the low pass filter 10, and in particular ten times as high as the cut-off frequency of the low pass filter 10. In absolute numbers, the cut-off frequency of the noise gain limiter is more than 50 kHz, and the cut-off frequency of the low pass filter 10 is less than 10 KHz. Generally, the cut-off frequency may be defined as frequency at which a voltage ratio between output and input is ~0,7. A frequency of the square wave voltage signal supplied by voltage source 5 may be in a range between 100 kHz and 1 MHz, for example.

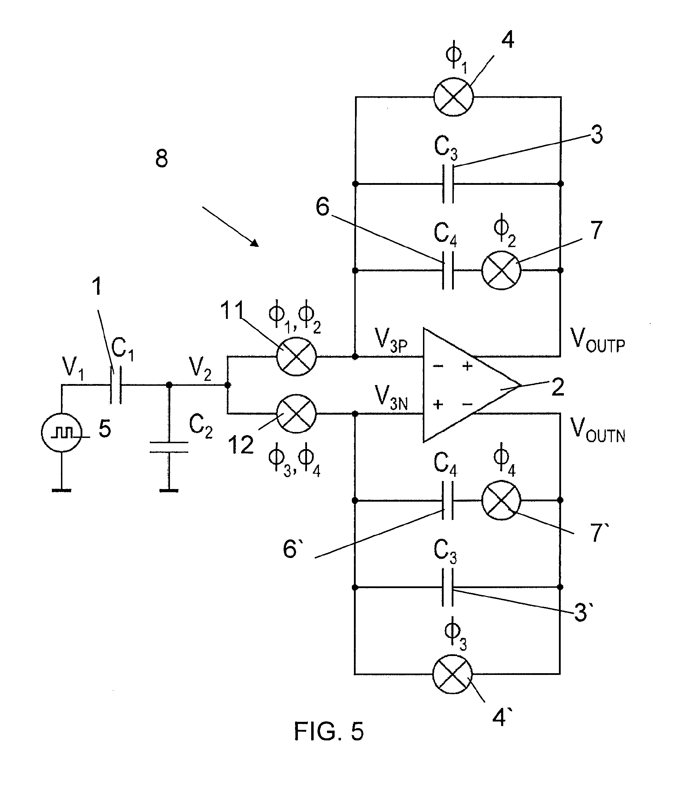

Figure 5 illustrates a sensor circuit arrangement according to a further embodiment of the present invention. This sensor circuit arrangement differs from the sensor circuit arrangement of Figure 3 by being embodied as a fully differential sensor circuit arrangement wherein the differential amplifier 2 is not connected to ground but relates to a negative switched capacitor branch instead. The sensor capacitor 1 thus is alternatively alternating connected to the differential inputs of the differential amplifier 2 by means of two additional switches 11 and 12. At the positive input $V_{3N}$ of the differential amplifier 2, the wiring of the negative input $V_{3P}$ is mirrored, and preferably provides elements with same dimensions. Hence, another first capacitor 3' is arranged in the second feedback loop between the positive input and a second output $V_{OUTN}$ of the differential amplifier 2, which other first capacitor 3' may be shunted by another first switch 4'. The noise gain limiting capacitor is referred to as another second capacitor 6' and is connectable in parallel to the other first capacitance 3' by means of another second switch 7'. The output of the differential amplifier 2 is $V_{OUTP}$ - $V_{OUTN}$. Hence, a fully-differential signal processing is proposed in this embodiment.

However, the transfer of the charge to the first capacitances 3, 3' is performed in a time-interleaved way. This means that switch 11 is closed during an entire cycle including the first phase $\Phi1$ and the second phase $\Phi2$ for the top circuit branch, i.e. the first feedback loop, in which first phase $\Phi1$ the sensor capacitor 1 is charged while the first switch 4 is closed and the second switch 7 is open, and in which second phase $\Phi2$ the charge is transferred from the sensor capacitor 1 to the first and second capacitor 3 and 6 while the first switch 4 is open and while the second switch 7 is closed. During the first and the second phase $\Phi1$ and $\Phi2$ the switch 11 remains closed while the switch 12 is open.

After having performed a cycle containing the first and the second phase $\Phi1$ and $\Phi2$ e.g. for the prescribed number of times, and preferably once, such that charge portions are transferred from the sensor capacitor 1 to the first and second capacitors 4 and 7 setting thereby the output voltage $V_{OUTP}$, the switch 11 is controlled to an open state and the switch 12 closes for the third and fourth phases $\Phi3$ and $\Phi4$ which are the equivalent to the first and the second phases $\Phi1$ and $\Phi2$ for the top branch, now for the bottom branch, i.e. the second feedback loop. In an equivalent manner, in the third phase $\Phi3$ the sensor capacitor 1 is charged while the other first switch 4' is closed and the other second switch 7' is open, and in the fourth phase $\Phi4$ the charge is transferred from the sensor capacitor 1 to the other first and second capacitors 3' and 6', the other first switch 4' is open while the other second switch 7' is closed. During the third and the fourth phase $\Phi3$ and $\Phi4$, the switch 12 remains closed while the switch 11 is open. After having performed the cycle containing the third and the fourth phase $\Phi3$ and $\Phi4$ e.g. for the prescribed number of times, and preferably once, such that charge portions are transferred from the sensor capacitor 1 to the other first and second capacitors 4' and 6' setting thereby the output voltage $V_{OUTN}$, the switch 11 is controlled to a closed state again and the switch 12 opens for the first and second phase $\Phi1$ and $\Phi2$ again.

At the end of such process, an analogue signal value corresponding to the capacitance of the sensor capacitor may be output from the circuit 8 by $V_{OUTP}$ - $V_{OUTN}$. Hence, a fully-differential front-end circuit 8 with a time interleaved use of the sensor capacitor 1 is proposed.

The above sensor circuit arrangement leads to a sensor signal $V_{OUTP}$ - $V_{OUTN}$ with twice the amplitude compared to the sensor signal $V_{OUTP}$ - $V_{OUTN}$ of Figure 3. However, the noise gain may in view of the bottom branch only be increased by a factor of $\sqrt{2}$ given that signal and noise are not correlated.

In the Figures, the various switches are labelled with the phases in which the respective switches are closed. For example, the first switch 4 is labelled $\Phi1$ in Fig. 5 which means that the first switch 4 is closed during the first phase $\Phi1$ and remains open else, i.e. during the second phase $\Phi2$. The second phase may also be denoted as complementary of the first phase, i.e. $\overline{\phi}1$.

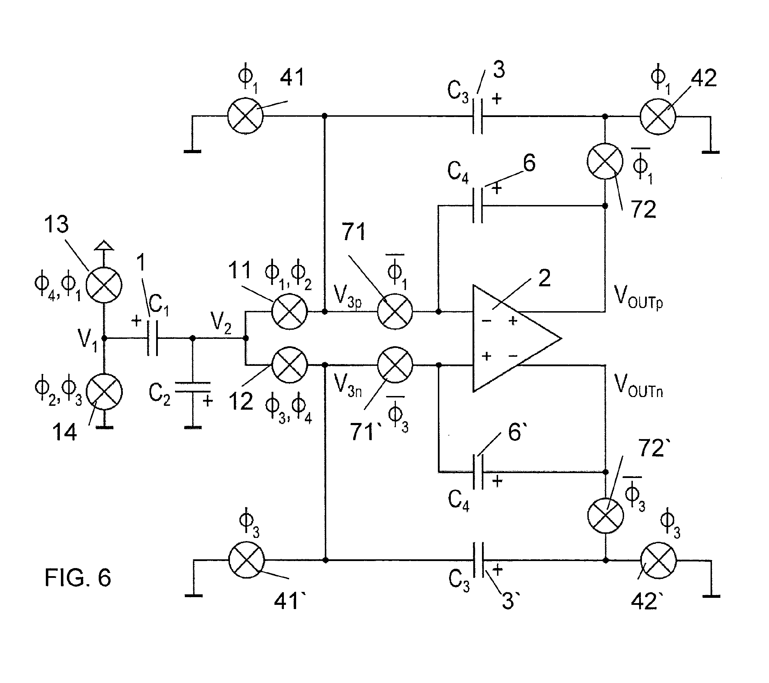

While the circuit of Fig. 5 may provide an output signal of alternating properties, a modification to the circuit of Fig. 5, may allow for a non-alternating property. Such modified circuit is shown in the block diagram of Fig. 6. The modification with respect to the circuit of Fig. 5 is only described with respect to the first feedback loop but is implemented in the second feedback loop as well. In contrast to Fig. 5, during the first phase $\Phi1$ the first capacitor 3 is no longer discharged with an effect to the output $V_{OUTP}$ given that the first capacitor 3 now is decoupled from the output $V_{OUTP}$ and from the input of the differential amplifier 2 during the first phase $\Phi1$ by the switches 71 and 72 which are open during the first phase $\Phi1$. In this first phase $\Phi1$, the first capacitor 3 is discharged via the switches 41 and 42, and the charging of the sensor capacitor 1 is effected by connecting the sensor capacitor 1 via the switches 11 and 41 to ground. During this first phase $\Phi1$ the second capacitor 6 is disconnected from ground via the switches 71 and 72 which are opened such that the second capacitor 6 holds its charge. In the second phase $\Phi2$ - wherein the switch 11 still remains closed according to its notation - the switches 41 and 42 are open, and the switches 71 and 72 are closed such that in the second phase $\Phi2$ the circuitry in the first feedback loop is identical to the circuitry in the first feedback loop of Fig. 5. In addition, the circuit of Fig. 6 shows an alternative to a voltage source 5 providing a square voltage signal. Instead, a DC source V1 is connected to the sensor capacitor 1 via switch 13 and to ground via switch 14. During the first phase $\Phi1$, the sensor capacitor 1 is connected to V1 via the closed switch 13 (switch 14 is open) and charges the sensor capacitor 1. During the second phase $\Phi2$, the senor capacitor 1 is connected to ground via the closed switch 14 (switch 13 is open).

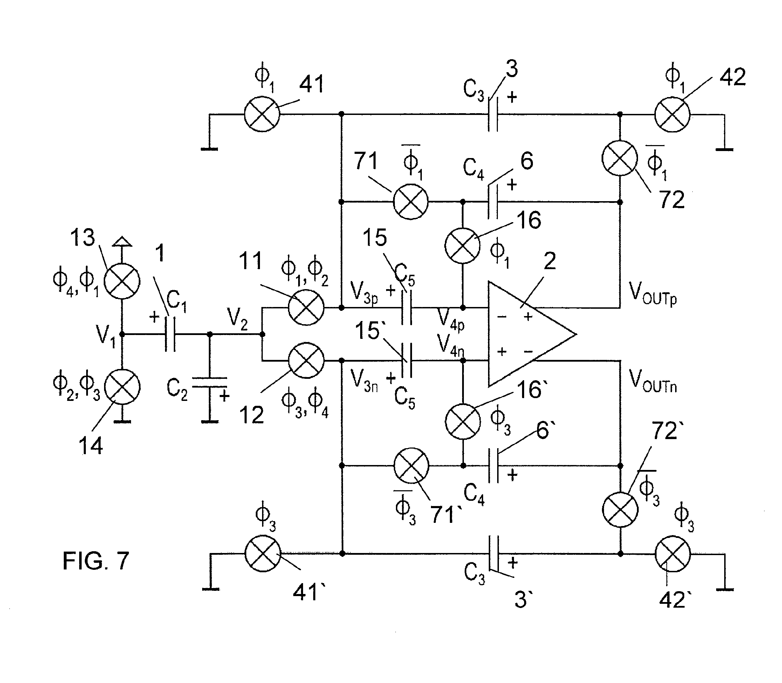

In the circuit of Fig. 6, in case of an offset between the inputs of the differential amplifier 2, the sensor signal $V_{OUTP}$ - $V_{OUTN}$ may be impacted by such offset. The circuit shown in the block diagram of Fig. 7 provides a mechanism for compensating such offset between the inputs $V_{4P}$ and $V_{4N}$ of the differential amplifier 2. In the first feedback loop, a third capacitor 15 is arranged between the switch 11 and the input $V_{4P}$ of the differential amplifier. By means of an adjusted switching arrangement including switch 16 being introduced in Fig. 7 between the second and the third capacitor 6 and 15, an offset induced charge is transferred to the third capacitor 15 during the first phase Φ1 in which the output $V_{OUTP}$ is fed back to the input $V_{4P}$ and the input $V_{4P}$ is connected to ground via the third capacitor 15 such that any offset at the input $V_{4P}$ charges the third capacitor 15. During the second phase Φ2, the third capacitor 15 is isolated via open switch 16.

**Claims**

1. Sensor circuit arrangement, comprising
a sensor capacitor (1) with a capacitance dependent on a variable to be measured,
a circuit (8) for determining the capacitance of the sensor capacitor (1) and supplying a corresponding sensor signal ($V_3$), the circuit (8) comprising

    - a differential amplifier (2) with an input, an output and a feedback loop between the input and the output,
    - a first capacitor (3) arranged in the feedback loop,
    - a switching arrangement for charging the sensor capacitor (1) from a voltage source (5) in a first phase (Φ1) and for transferring a charge from the sensor capacitor (1) to the first capacitor (3) in a second phase(Φ2), and
    - a second capacitor (6) connected in parallel to the first capacitor (3) in the second phase (Φ2) for limiting a gain of noise generated by the differential amplifier (2),

a low pass filter (10) for filtering the sensor signal ($V_3$).

2. Sensor circuit arrangement according to claim 1,
wherein the differential amplifier (2) includes an operational amplifier,
wherein the sensor capacitor (1) is connected or is connectable to the input of the operational amplifier,
wherein the first capacitor (3) is connected or is connectable to the input and to the output of the operational amplifier, and
wherein the second capacitor (6) is connected or is connectable to the input and to the output of the operational amplifier.

3. Sensor circuit arrangement according to claim 1 or claim 2,
wherein the switching arrangement is adapted to short-circuit the first capacitor (3) in the first phase (Φ1) by means of a first switch (4) and is adapted to release the short-circuit in the second phase (Φ2), and
wherein the switching arrangement is adapted to connect the second capacitor (6) in parallel to the first capacitor (3) in the second phase (Φ2) by means of a second switch (7) and to release the parallel circuit in the first phase (Φ1).

4. Sensor circuit arrangement according to claim 3, wherein the switching arrangement is adapted to connect the second capacitor (6) in parallel to the first capacitor (3) by means of the second switch (7) during an interval within the second phase (Φ2).

5. Sensor circuit arrangement according to any one of the preceding claims,
wherein the switching arrangement is adapted to repeat a cycle containing the first phase (Φ1) and the second phase (Φ2) for a prescribed number of times,
wherein the output of the differential amplifier (2) supplies the sensor signal ($V_3$) in an analogue format after each repetition of the prescribed number of cycles, and
wherein the sensor circuit arrangement comprises an analogue to digital converter (9) for converting the sensor signal ($V_3$) from its analogue format into a digital format ($D_3$).

6. Sensor circuit arrangement according to claim 5, wherein the analogue to digital converter (9) includes the low-pass filter (10).

7. Sensor circuit arrangement according to any one of the preceding claims,
wherein a capacitance of the second capacitor (6) is at least five times as high as a capacitance of the first capacitor (3), and
in particular wherein the capacitance of the second capacitor (6) is at least ten times as high as the capacitance of the first capacitor (3).

8. Sensor circuit arrangement according to any one of the preceding claims,
wherein a cut-off frequency of the low pass filter is less than 10 KHz.

9. Sensor circuit arrangement according to any one of the preceding claims,
wherein the voltage source (5) is adapted to supply a square wave voltage signal and is connected to the sensor capacitor (1), and
wherein the switching arrangement is adapted to synchronize a zero voltage phase in the square wave voltage signal with the second phase (Φ2).

10. Sensor circuit arrangement,
wherein the differential amplifier (2) is a single ended differential amplifier wherein the output is the single output of the differential amplifier (2).

11. Sensor circuit arrangement according to any one of the preceding claims 1 to 9,

wherein the differential amplifier (2) is a fully differential amplifier containing two differential inputs and two differential outputs and two feedback loops each between the corresponding input and output,
wherein a first capacitor (3,3') and a second capacitor (6,6') are arranged in each feedback loop,
wherein during a first feedback loop phase ($\Phi$1, $\Phi$2) spanning the first phase ($\Phi$1) and the second phase ($\Phi$2) applied to the first feedback loop the switching arrangement is adapted to connect the sensor capacitor (1) to the first input and to disconnect the sensor capacitor (1) from the second input, and
wherein during a second feedback loop phase ($\Phi$3, $\Phi$4) spanning a third phase ($\Phi$3) and a fourth phase ($\Phi$4) applied to the second feedback loop corresponding to the first phase ($\Phi$1) and the second phase ($\Phi$2) as applied to the first feedback loop the switching arrangement is adapted to connect the sensor capacitor (1) to the second input and to disconnect the sensor capacitor (1) from the first input.

12. Sensor circuit arrangement according to claim 11, wherein the switching arrangement is adapted to disconnect each first capacitor (3,3') from the corresponding input and output of the fully differential amplifier (2) during the first phase ($\Phi$1) and the third phase ($\Phi$3) respectively.

13. Sensor circuit arrangement according to claim 12, wherein a third capacitor (15,15') is connected to each input of the fully differential amplifier for compensating for an offset between the inputs of the fully differential amplifier.

14. Method for determining a capacitance of a sensor capacitor, comprising
in a first phase ($\Phi$1) charging the sensor capacitor (1) from a voltage source (5),
in a second phase ($\Phi$2) transferring a charge from the sensor capacitor (1) to a first capacitor (3) arranged in a feedback loop of a differential amplifier (2) to which first capacitor (3) a second capacitor (6) is connected in parallel in the second phase ($\Phi$2) for limiting a gain of noise generated by the differential amplifier (2),
deriving a sensor signal ($V_3$) corresponding to the capacitance of the sensor capacitor (1) from an output of a circuit (8) containing the differential amplifier (2), and
low-pass filtering the sensor signal ($V_3$).

15. Method according to claim 14,
wherein the sensor signal ($V_3$) is supplied in an analogue format and is converted into a digital format, and
wherein the sensor signal ($V_3$) is low-pass filtered after being converted into the digital format.

FIG. 1

FIG. 2

FIG. 3

FIG. 4

FIG. 5

FIG. 6

EP 2 799 891 A1

FIG. 7

Europäisches
Patentamt

European
Patent Office

Office européen
des brevets

**EUROPEAN SEARCH REPORT**

Application Number

EP 13 00 2385

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2012 037439 A (ASAHI KASEI DENSHI KK) 23 February 2012 (2012-02-23) * paragraph [0017] - paragraph [0036]; figures 1, 2, 10, 11 * * paragraph [0056] - paragraph [0066] * | 1-15 | INV. G01R27/26 G01D5/24 |
| X | US 2010/013502 A1 (KUANG YU [TW]) 21 January 2010 (2010-01-21) * paragraph [0029] - paragraph [0033]; figures 1, 2 * | 1,10,14 | |
| X | US 2003/011384 A1 (ISHIO SEIICHIRO [JP] ET AL) 16 January 2003 (2003-01-16) * paragraph [0043] - paragraph [0081]; figures 2, 3A, 3B * | 1,10,14 | |
| A | US 2012/056630 A1 (ITOU HIROKAZU [JP] ET AL) 8 March 2012 (2012-03-08) * paragraph [0026]; figure 1 * | 1-15 | |
| A | US 2002/135384 A1 (STRACK PETER [FR] ET AL) 26 September 2002 (2002-09-26) * paragraph [0053] - paragraph [0064]; figures 7, 8 * | 1-15 | TECHNICAL FIELDS SEARCHED (IPC) G01R G01D |
| A | US 2010/102831 A1 (KUANG YU [TW]) 29 April 2010 (2010-04-29) * paragraph [0034] - paragraph [0037]; figures 5, 7 * | 1-15 | |

The present search report has been drawn up for all claims

| Place of search | Date of completion of the search | Examiner |
|---|---|---|
| Berlin | 30 September 2013 | Koll, Hermann |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 13 00 2385

This annex lists the patent family members relating to the patent documents cited in the above-mentioned European search report.
The members are as contained in the European Patent Office EDP file on
The European Patent Office is in no way liable for these particulars which are merely given for the purpose of information.

30-09-2013

| Patent document cited in search report | Publication date | Patent family member(s) | | Publication date |
|---|---|---|---|---|
| JP 2012037439 A | 23-02-2012 | NONE | | |
| US 2010013502 A1 | 21-01-2010 | TW | 201005302 A | 01-02-2010 |
| | | US | 2010013502 A1 | 21-01-2010 |
| US 2003011384 A1 | 16-01-2003 | DE | 10231153 A1 | 27-02-2003 |
| | | JP | 4508480 B2 | 21-07-2010 |
| | | JP | 2003028825 A | 29-01-2003 |
| | | US | 2003011384 A1 | 16-01-2003 |
| US 2012056630 A1 | 08-03-2012 | JP | 2012078337 A | 19-04-2012 |
| | | US | 2012056630 A1 | 08-03-2012 |
| US 2002135384 A1 | 26-09-2002 | CN | 1386187 A | 18-12-2002 |
| | | DE | 10035192 C1 | 11-10-2001 |
| | | US | 2002135384 A1 | 26-09-2002 |
| | | WO | 0208697 A1 | 31-01-2002 |
| US 2010102831 A1 | 29-04-2010 | TW | 201017184 A | 01-05-2010 |
| | | US | 2010102831 A1 | 29-04-2010 |

EPO FORM P0459

For more details about this annex : see Official Journal of the European Patent Office, No. 12/82